# EUROPEAN PATENT SPECIFICATION

(11) **EP 4 611 511 B1**
(45) Date of publication and mention of the grant of the patent: **02.12.2026**
(21) Application number: 22963563.6
(22) Date of filing: 26.10.2022
(51) Int. Cl.: G02F 1/1333, H10K 50/80, G09F 9/33, H10K 59/80

(54) **DISPLAY DEVICE**
ANZEIGEVORRICHTUNG
DISPOSITIF D'AFFICHAGE

(43) Date of publication of application: 03.09.2025
(73) Proprietor: LG Electronics Inc., Yeongdeungpo-gu Seoul 07336 (KR)
(72) Inventor: LIM, Byungkil, Seoul 06772 (KR); LEE, Kyoungjoon, Seoul 06772 (KR); KIM, Doyoung, Seoul 06772 (KR)
(74) Representative: Vossius & Partner Patentanwälte Rechtsanwälte mbB
(86) International application number: PCT/KR2022/016429
(87) International publication number: WO 2024/090602

(56) References cited:
- KR-A- 20150 028 142
- KR-A- 20200 076 852
- KR-A- 20210 088 343
- KR-A- 20210 088 343
- KR-B1- 101 832 301
- KR-B1- 102 224 632
- US-A1- 2019 281 709
- US-A1- 2022 046 810

## Description

### [Technical Field]

The present disclosure relates to a display device.

### [Background Art]

With the development of information society, there has been a growing demand for various types of display devices. In order to meet such demand, various display devices, such as a liquid crystal display (LCD) device, a plasma display panel (PDP), an electro luminescent display (ELD), a vacuum fluorescent display (VFD), an organic light emitting diode (OLED) display, and the like, have been developed and used.

Among them, a display device using an organic light emitting diode (OLED) has excellent luminance and viewing angle characteristics compared to a liquid crystal display device, and requires no backlight unit, which is advantageous to achieve an ultra-thin profile.

Recently, numerous research has been conducted on a structure for ensuring the rigidity of an ultra-thin large screen display device and for dissipating heat due to high image quality.

US 2019/281709 A1 discloses a display apparatus capable of implementing to be slim and lightweight. The display apparatus includes a display panel for displaying an image; a bottom chassis disposed in a rear of the display panel; and wherein the bottom chassis is formed with a panel including a plastic core and a planar material stacked on a side of the plastic core.

### [Disclosure]

### [Technical Problem]

It is an object of the present disclosure to solve the above and other problems.

It is another object of the present disclosure to ensure structural rigidity of an ultra-thin large screen display device.

It is another object of the present disclosure to prevent thermal deformation of a display device and ensure high temperature reliability.

### [Technical Solution]

In accordance with an aspect of the present invention, the above objects can be accomplished by providing a display device as defined in independent claim 1. Preferred aspects are defined in the dependent claims.

### [Advantageous Effects]

A display device according to the present disclosure has the following effects.

According to at least one of the embodiments of the present disclosure, it is possible to ensure structural rigidity of an ultra-thin large screen display device.

According to at least one of the embodiments of the present disclosure, it is possible to prevent thermal deformation of a display device and ensure high temperature reliability.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### [Brief Description of Drawings]

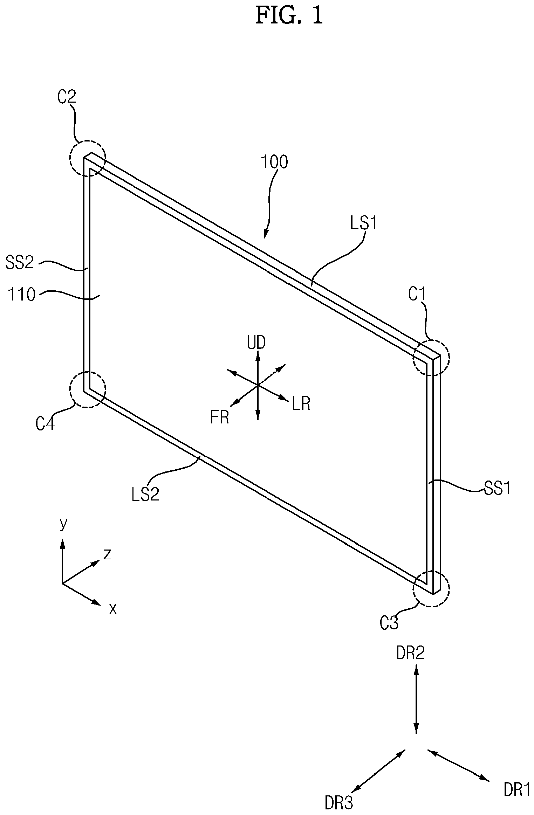

FIGS. 1 to 28 are diagrams illustrating examples of a display device according to embodiments of the present disclosure.

### [Mode for the Invention]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand various technical features and it should be understood that the embodiments disclosed herein are not limited by the accompanying drawings. As such, the present disclosure should be construed to extend to any alterations, equivalents, and substitutes in addition to those which are particularly set out in the accompanying drawings.

Although the terms "first", "second", etc. may be used herein to describe various elements, these elements should not be limited by these terms. These terms are only used to distinguish one element from another.

It will be understood that when a component is referred to as being "coupled" or "connected" to another component, it may be directly coupled or connected to another component, or intervening components may be present. In contrast, when a component is referred to as being "directly coupled" or "directly connected" to another component, there are no intervening components present.

A singular representation may include a plural representation unless the context clearly indicates otherwise.

In the following description, when an embodiment is described with reference to a specific figure, reference numeral not shown in the specific figure may be mentioned, if necessary or desired. However, the reference numeral not shown in the specific figure may be mentioned only when the reference numeral is shown in other figures.

Referring to FIG. 1, a display device 100 includes a display panel 110. The display panel 110 may display an image.

The display device 100 may include a first long side LS1, a second long side LS2 opposite the first long side LS1, a first short side SS1 adjacent to the first long side LS1 and the second long side LS2, and a second short side SS2 opposite the first short side SS1.

For ease of explanation, it is illustrated and described that lengths of the first and second long sides LS1 and LS2 are greater than lengths of the first and second short sides SS1 and SS2, but the lengths of the first and second long sides LS1 and LS2 may be substantially equal to the lengths of the first and second short sides SS1 and SS2.

A direction parallel to the long sides LS1 and LS2 of the display device 100 may be referred to as a first direction DR1 or a left-and-right direction LR. A direction parallel to the short sides SS1 and SS2 of the display device 100 may be referred to as a second direction DR2 or an up-and-down direction UD.

A direction perpendicular to the long sides LS1 and LS2 and the short sides SS1 and SS2 of the display device 100 may be referred to as a third direction DR3 or a front-and-rear direction FR. Here, a direction in which the display panel 110 displays an image may be referred to as a front, and a direction opposite to the front may be referred to as a rear.

Hereinafter, a display panel using an organic light emitting diode (OLED) will be described as an example for the display panel 110, but the display panel 110 applicable to the present disclosure is not limited thereto.

The display panel 110 may define a front surface of the display device 100, and may display an image forward. The display panel 110 may include a plurality of pixels to output an image in accordance with color, brightness, and chroma of each pixel. The display panel 110 may be divided into an active area in which an image is displayed and a de-active area in which no image is displayed. The display panel 110 may generate light corresponding to red, green, or blue color in response to a control signal.

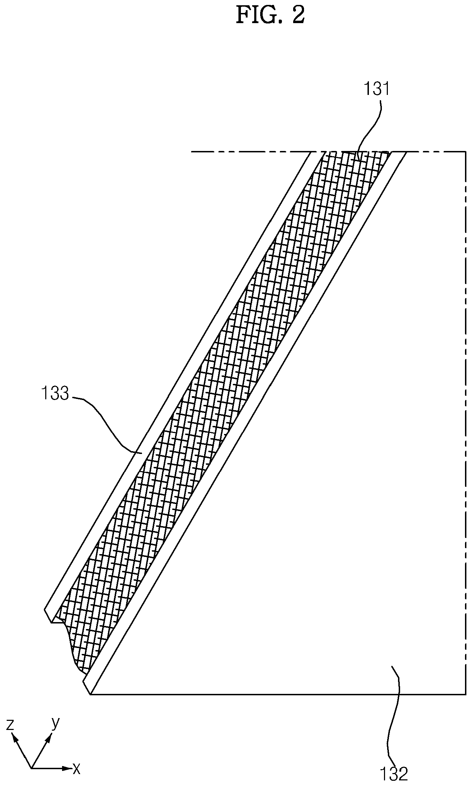

Referring to FIG. 2, a material complexed panel 130 includes a core 131, a front skin 132, and a rear skin 133. The core 131, the front skin 132, and the rear skin 133 may be coupled to each other. The material complexed panel 130 may be referred to as a fiber complexed panel 130, a fiber complexed plate 130, a material complexed plate 130, or a middle frame 130.

The front skin 132 defines a front surface of the material complexed panel 130. The rear skin 133 defines a rear surface of the material complexed panel 130. The front skin 132 and the rear skin 133 may include a metal material.

For example, the front skin 132 and the rear skin 133 may be made of galvanized iron. As another example, the front skin 132 and the rear skin 133 may include aluminum (Al).

For example, the front skin 132 and the rear skin 133 may have a thickness of 0.2 to 0.5 mm. As another example, the thickness of the front skin 132 and the rear skin 133 formed of galvanized iron may be 0.27 mm. As another example, the thickness of the front skin 132 and the rear skin 133 containing aluminum (Al) may be 0.5 mm.

The front skin 132 and the rear skin 133 may be opposite each other with respect to the core 131 described below. The core 131 may be positioned between the front skin 132 and the rear skin 133. The core 131 includes fibers. The core 131 may be formed of a composite material. The core 131 may include a main fiber and a binder fiber. The binder fiber may be mixed with the main fiber.

The front skin 132 and/or the rear skin 133 may be coupled to the core 131 by hot-melt processing. A hot-melt sheet may be disposed between the front skin 132 and the core 131, and a hot-melt sheet may be disposed between the rear skin 133 and the core 131. The hot-melt sheet may be a film. For example, the hot-melt sheet may be a film made of EVA, acrylic, polyurethane, or the like having a thickness of 50 µm or more. After the core 131 is placed between the front skin 132 and the rear skin 133 by the hot-melt sheets, roll lamination may be performed at 190 °C for 1 minute or more.

Accordingly, it is possible to increase bending rigidity and/or torsional rigidity of the display device.

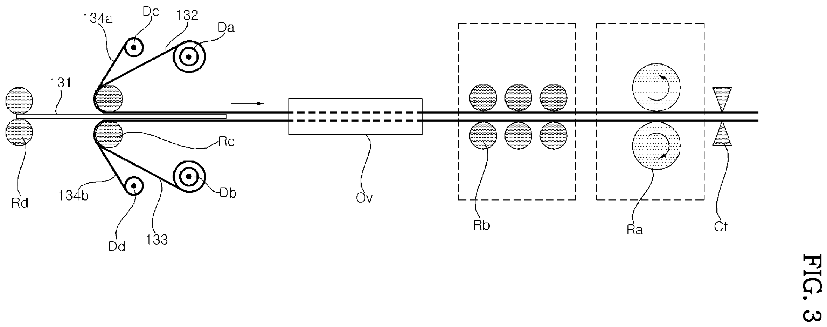

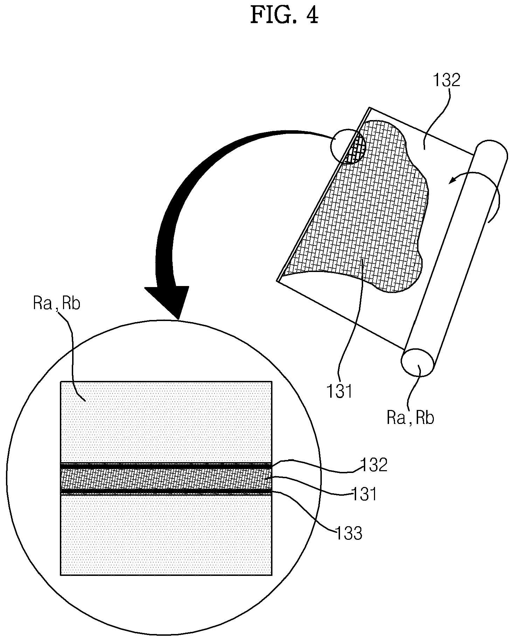

Referring to FIGS. 3 and 4, the material complexed panel 130 may be manufactured by a process of pressing the front skin 132 and the rear skin 133 onto the core 131 using a plurality of rollers. Such a process may be referred to as a Roll-to-Roll (R2R) process.

Referring to FIG. 3, as a pinch roller Ra serving as a drive motor rotates, the front skin 132 may be unwound from a front drum Da, the rear skin 133 may be unwound from a rear drum Db, and the core 131 may be moved by passing through a feeding roller Rd. In addition, a first adhesive 134a for coupling the front skin 132 to the core 131 may be unwound from a first drum Dc. Also, a second adhesive 134b for coupling the rear skin 133 to the core 131 may be unwound from a second drum Db. In this case, the front skin 132, the first adhesive 134a, the core 131, the second adhesive 134b, and the rear skin 133 are stacked in this order, and may be guided toward an oven Ov by a guide roller Rc. The adhesive 134a, 134b may be a hot-melt sheet 134a, 134b.

As the first and second adhesives 134a and 134b are melted in the oven Ov, each of the front skin 132 and the rear skin 133 may be coupled to the core 131. For example, the melting point of the first and second adhesives 134a and 134b may be about 150 °C, and the ambient temperature of the oven Ov may be about 200 °C. For example, the peel-off force of the first and second adhesives 134a and 134b may be about 10 kgf or more.

The front skin 132, the core 131, and the rear skin 133 that have passed through the oven Ov may be guided to a press roller Rb by the rotation of the pinch roller Ra so as to be pressed by the press roller Rb. Accordingly, the coupling force among the front skin 132, the core 131, and the rear skin 133 may be further increased. The front skin 132, the core 131, and the rear skin 133, which are coupled together, may pass through the pinch roller Ra, and then may be cut by a cutter Ct to be manufactured as a material complexed panel 130 of a predetermined size.

Referring to FIG. 4, the press roller Rb or the pinch roller Ra may come into contact with an outer surface of each of the front skin 132 and the rear skin 133. When the press roller Rb or the pinch roller Ra rotates, the material complexed panel 130 may be moved in a longitudinal direction of the core 131 (i.e., the left-and-right direction LR). Here, the front skin 132 and the rear skin 133 may be sequentially coupled from one end to the other end of the core 131 in the longitudinal direction of the core 131.

In addition, the front skin 132 and the rear skin 133 of the material complexed panel 130 may be formed flat. That is, as a rear surface of the rear skin 133 that defines a rear surface of the display device 100 is formed flat, it may facilitate an additional operation, such as painting the rear surface of the rear skin 133, attaching a sheet thereto, or the like, for an aesthetically pleasing appearance.

Meanwhile, in addition to the R2R process described above with reference to FIGS. 3 and 4, which is used for making the front skin 132 and the rear skin 133 flat, a process of sequentially stacking the front skin 132, the core 131, and the rear skin 133 followed by coupling the same may also be used.

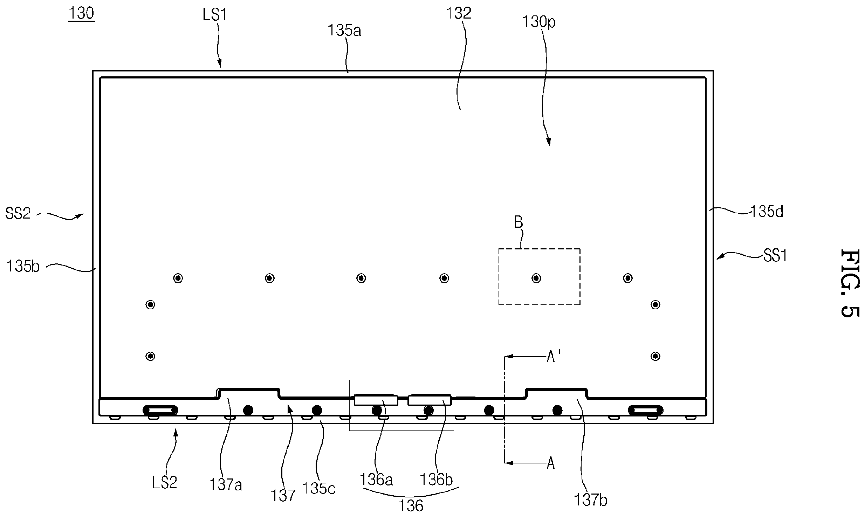

Referring to FIG. 5, the material complexed panel 130 may include a flat plate part 130P, a receiving part 137, and an outer part 135. The outer part 135 may be formed around the flat plate part 130P. A first outer part 135a may be formed along an upper side of the flat plate part 130P, a second outer part 135b may be formed along a left side of the flat plate part 130P, a third outer part 135c may be formed along a lower side of the flat plate part 130P, and a fourth outer part 135d may be formed along a right side of the flat plate part 130P. The outer part 135 may be formed in such a manner that the flat plate part 130P is pressed. The outer part 135 may be lowered from the flat plate part 130P, thereby forming a step. A thickness of the flat plate part 130P may be greater than a thickness of the outer part 135.

A cable hole 136 may be formed through the front skin 132 (see FIG. 2) and the rear skin 133 (see FIG. 2) of the receiving part 137. The cable hole 136 may be formed in the receiving part 137 while being adjacent to the lower side of the flat plate part 130P. The cable hole 136 may be provided in plurality. A first cable hole 136a and a second cable hole 136b may be positioned adjacent to each other.

The receiving part 137 may be formed between the flat plate part 130P and the third outer part 135c while being adjacent to the lower side of the flat plate part 130P. The receiving part 137 may be provided in plurality. A first receiving part 137a may be positioned between the first cable hole 136a and the second short side SS2. A second receiving part 137b may be positioned between the second cable hole 136b and the first short side SS1. The receiving part 137 may be formed in such a manner that the flat plate part 130P is pressed. The receiving part 137 may be lowered from the flat plate part 130P and/or the outer part 135c, thereby forming a step.

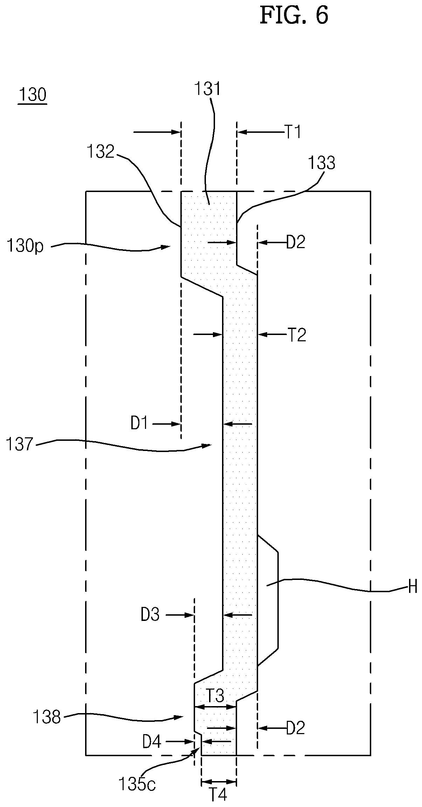

Referring to FIG. 6, the receiving part 137 may be formed in such a manner that the flat plate part 130P is pressed. The front skin 132 of the receiving part 137 may form a step D1 descending from the front skin 132 of the flat plate part 130P. The rear skin 133 of the receiving part 137 may form a step D2 ascending from the rear skin 133 of the flat plate part 130P. Here, a height of the step D1 descending from the front skin 132 of the flat plate part 130P to the front skin 132 of the receiving part 137 may be greater than a height of the step D2 ascending from the rear skin 133 of the flat plate part 130P to the rear skin 133 of the receiving part 137. A thickness T1 of the flat plate part 130P may be greater than a thickness T2 of the receiving part 137.

As the core 131 of the material complexed panel 130 is pressed in a direction from the front skin 132 to the rear skin 133 of the flat plate part 130P, the core 131 may absorb an external force. The magnitude of the external force applied to the front skin 132 of the flat plate part 130P may be greater than the magnitude of the external force applied to the rear skin 133 of the flat plate part 130P. The core 131 of the material complexed panel 130 may not only absorb impact but also ensure rigidity.

A thickness T4 of the third outer part 135c may be greater than the thickness T2 of the receiving part 137. A step D2 ascending from the rear skin 133 of the third outer part 135c to the rear skin 133 of the receiving part 137 may be formed. A height of the step D2 between the rear skin 133 of the third outer part 135c and the rear skin 133 of the receiving part 137 may be equal to the height of the step D2 between the rear skin 133 of the receiving part 137 and the rear skin 133 of the flat plate part 130P.

A protruding pad 138 may be formed to protrude from the front skin 132 of the third outer part 135c. The front skin 132 of the protruding pad 138 may form a step D4 descending to the front skin 132 of the third outer part 135c. A height of the step D4 formed by the third outer part 135c and the protruding pad 138 may be less than the height of the steps D1 and D2 formed by the flat plate part 130P and the receiving part 137. A step D3 descending from the front skin 132 of the protruding pad 138 to the front skin 132 of the receiving part 137 may be formed. A thickness T3 of the protruding pad 138 may be greater than the thickness T4 of the third outer part 135c, may be less than the thickness T1 of the flat plate part 130P, and may be less than the thickness T2 of the receiving part 137.

A fastening groove H may protrude from the rear skin 133 of the receiving part 137. The fastening groove H may be recessed in the front skin 132 of the receiving part 137 and may protrude from the rear skin 133 of the receiving part 137. A central portion of the fastening groove H may be penetrated.

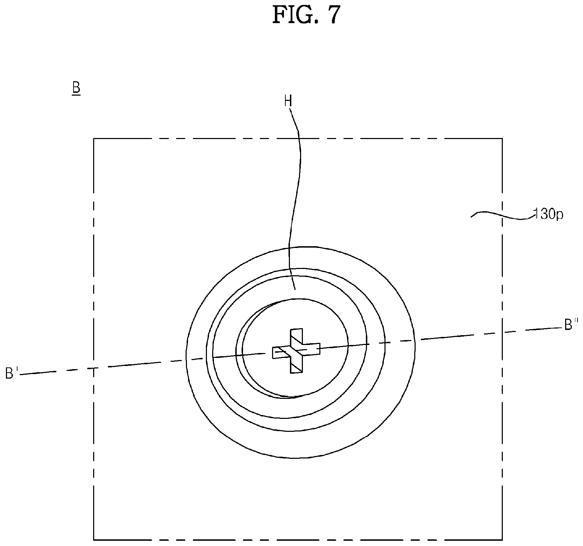

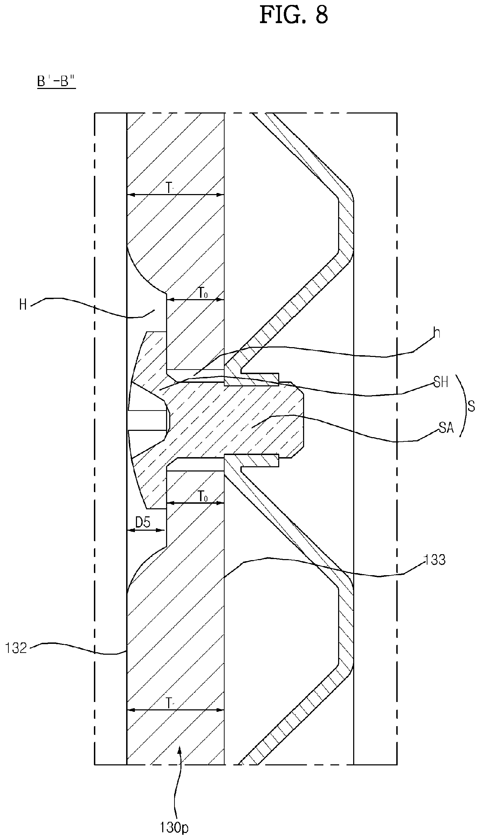

Referring to FIGS. 7 and 8, the fastening groove H may be formed in the flat plate part 130P. The fastening groove H may be formed in such a manner that the flat plate part 130P is pressed. The front skin 132 of the fastening groove H may be formed by being recessed from the front skin 132 of the flat plate part 130P. The rear skin 133 of the flat plate part 130P and the rear skin 133 of the fastening groove H may form the same plane. A thickness T0 of the fastening groove H may be less than the thickness T1 of the flat plate part 130P.

The fastening groove H may be provided at its center with a fastening hole h. The fastening hole h may be formed by punching the fastening groove H. The fastening hole h may be formed through the front skin 132 and the rear skin 133 of the fastening groove H. A shaft SA of a fastening member S may have a length greater than the thickness T0 of the fastening groove H. The shaft SA of the fastening member S may be inserted into the fastening groove H and protrude to the outside of the rear skin 132 of the fastening groove H through the fastening hole h. A depth D5 of the fastening groove H may be greater than a thickness of a head SH. The head SH of the fastening member S may be hidden in the fastening groove H.

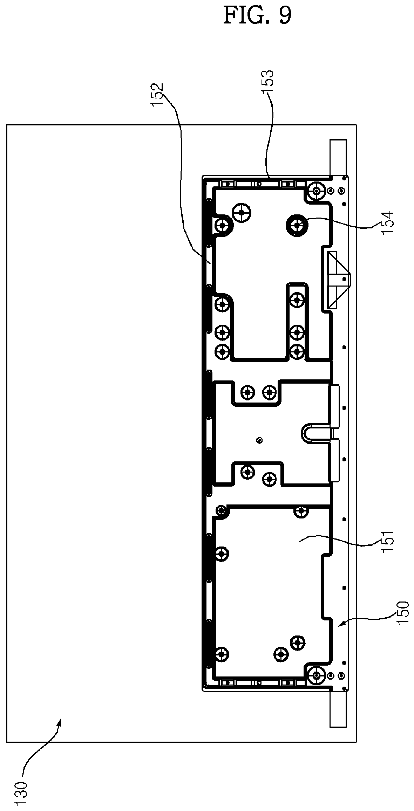

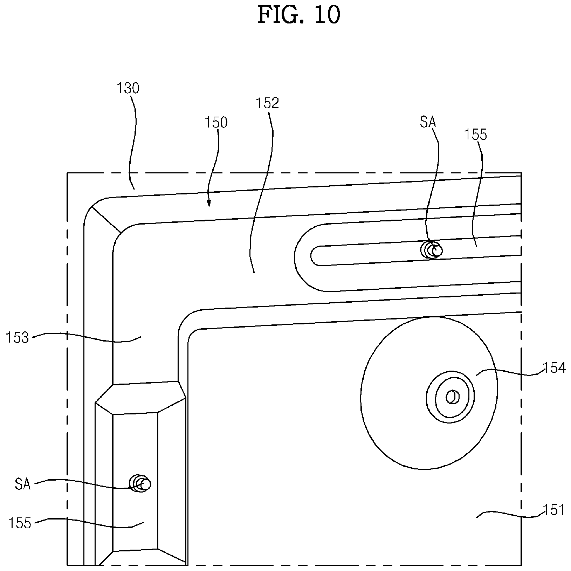

Referring to FIGS. 9 and 10 along with FIG. 8, a PCB plate 150 may be coupled to the rear of the material complexed panel 130. The PCB plate 150 may be fixed to the rear of the material complexed panel 130 by the fastening member S.

The PCB plate 150 may be formed in such a manner that a plate 151 including a metal is pressed. The PCB plate 150 may include a horizontal portion 152, a vertical portion 153, a dome portion 154, and a recessed portion 155. The horizontal portion 152 may protrude from the front to the rear of the PCB plate 151, and may be elongated in a left-and-right direction of the PCB plate 151. The vertical portion 153 may protrude from the front to the rear of the PCB plate 151, and may be elongated in an up-and-down direction of the PCB plate 150. The dome portion 154 may protrude from the front to the rear of the PCB plate 150. The recessed portion 155 may be recessed forward from the rear of the vertical portion 153 and/or the horizontal portion 152.

The shaft SA of the fastening member S may pass through the recessed portion 155 formed in the vertical portion 153 and/or the horizontal portion 152 to couple the material complexed panel 130 with the PCB plate 150. A depth of the recessed portion 155 may be greater than a protruding length of the shaft SA of the fastening member S that protrudes rearward through the material complexed panel 130.

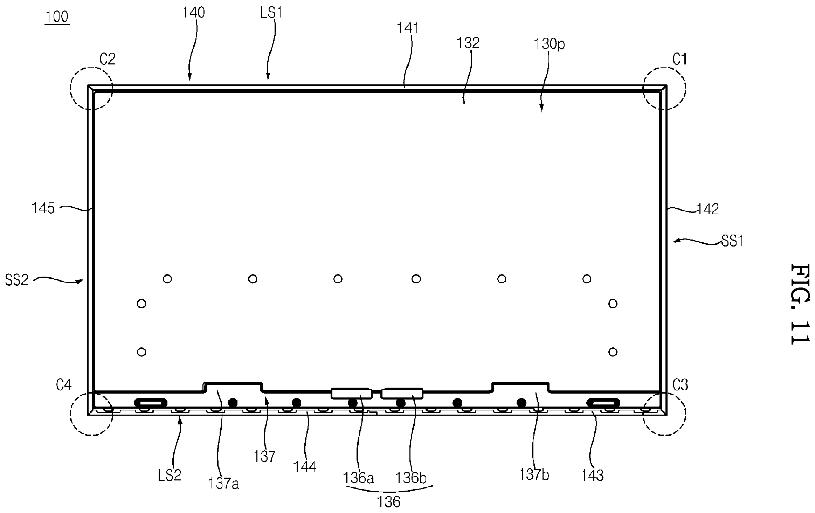

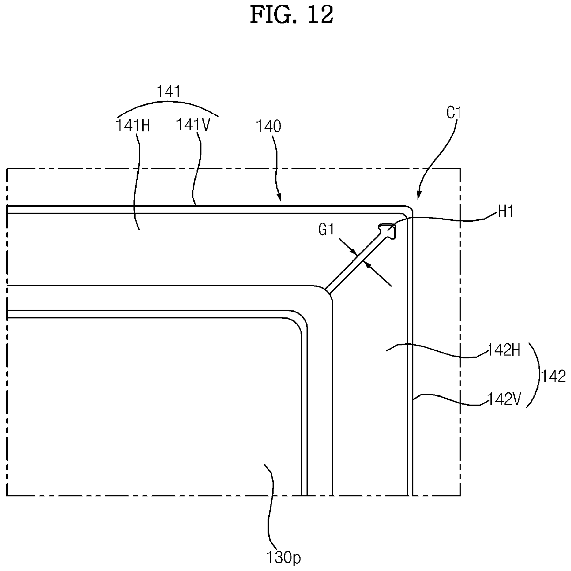

Referring to FIGS. 11 and 12, a side frame 140 may be coupled to the outer part 135 (see FIG. 5) while being adjacent to the flat plate part 130P. The side frame 140 may include a first part 141, a second part 142, a third part 143, a fourth part 144, and a fifth part 145. The second part 142 may be bent at a first corner C1 from the first part 141.

The first part 141 may include a horizontal portion 141H and a vertical portion 141V. The horizontal portion 141H of the first part 141 may be fixed onto the first outer part 135a (see FIG. 5). The second part 142 may include a horizontal portion 142H and a vertical portion 142V. The horizontal portion 142H of the second part 142 may be fixed onto the fourth outer part 135d (see FIG. 5).

A gap G1 may be formed between the horizontal portion 141H of the first part 141 and the horizontal portion 142H of the second part 142. The vertical portion 141V of the first part 141 and the vertical portion 142V of the second part 142 may be connected while being bent. A hole H1 connected to the gap G1 may be formed between the horizontal portions 141H and 142H while being adjacent to the vertical portions 141V and 142V. A size of the hole H1 or a diameter of the hole H1 may be greater than a width of the gap G1. The description of the first corner C1 of the side frame 140 is equally applicable to a second corner C2 of the side frame 140.

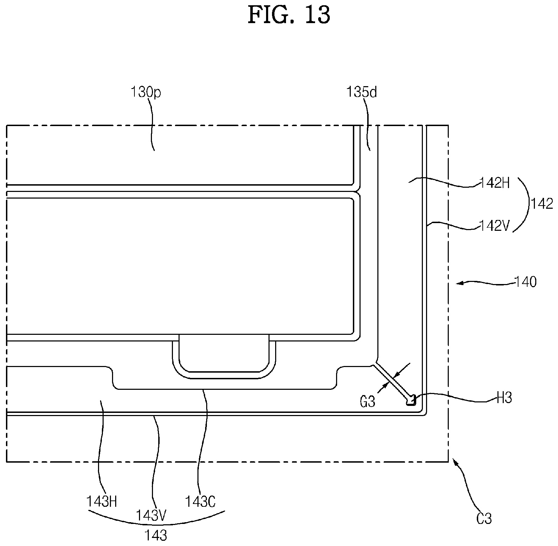

Referring to FIG. 11 and FIG. 13, the side frame 140 may be coupled to the outer part 135 (see FIG. 5) while being adjacent to the flat plate part 130P. The side frame 140 may include a first part 141, a second part 142, a third part 143, a fourth part 144, and a fifth part 145. The second part 142 may be bent at a third corner C3 from the third part 143.

The third part 143 may include a horizontal portion 143H and a vertical portion 143V. The horizontal portion 143H of the third part 143 may be fixed onto the third outer part 135c (see FIG. 5). The second part 142 may include a horizontal portion 142H and a vertical portion 142V. The horizontal portion 142H of the second part 142 may be fixed onto the fourth outer part 135d (see FIG. 5).

A gap G3 may be formed between the horizontal portion 143H of the third part 143 and the horizontal portion 142H of the second part 142. The vertical portion 143V of the third part 143 and the vertical portion 142V of the second part 142 may be connected while being bent. A hole H3 connected to the gap G3 may be formed between the horizontal portions 143H and 142H while being adjacent to the vertical portions 143V and 142V. A size of the hole H3 or a diameter of the hole H3 may be greater than a width of the gap G3. The description of the third corner C3 of the side frame 140 is equally applicable to a fourth corner C4 of the side frame 140.

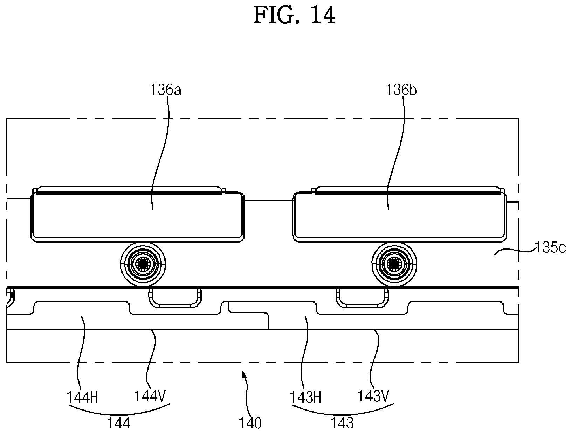

Referring to FIG. 11 and FIG. 14, the third part 143 and the fourth part 144 of the side frame 140 may be positioned on or fixed onto the third outer part 135c. An end of the third part 143 of the side frame 140 may be coupled to an end of the fourth part 144 of the side frame 140.

A horizontal portion 144H of the fourth part 144 may be in contact with the horizontal portion 143H and the vertical portion 143V of the third part 143. A vertical portion 144V of the fourth part 144 may be in contact with the vertical portion 143V of the third part 143. The vertical portion 143V of the third part 143 may be in contact with the horizontal portion 144H and the vertical portion 144V of the fourth part 144. The end of the third part 143 may be fixed to the end of the fourth part 144. For example, the end of the third part 143 and the end of the fourth part 144 may be fixed by welding.

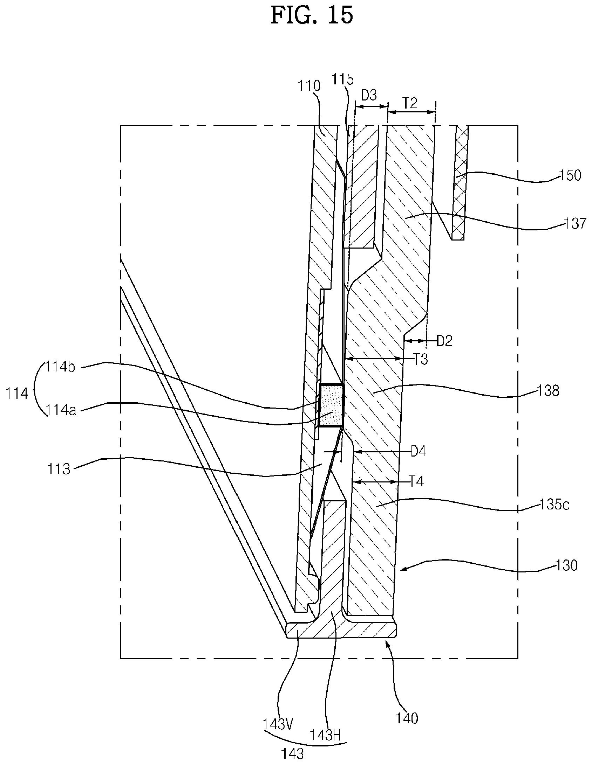

Referring to FIG. 15, the display panel 110 may be coupled or fixed onto the side frame 140. The horizontal portion 143H of the side frame 140 may support a rear surface of the display panel 110, and the vertical portion 143V of the side frame 140 may cover a side surface of the display panel 110. For example, the vertical portion 143V of the third part 143 of the side frame 140 may cover a lower side surface of the display panel 110.

The vertical portion 143V may cover a side surface of the material complexed panel 130. For example, the vertical portion 143V of the third part 143 of the side frame 140 may cover a side surface of the third outer part 135c of the material complexed panel 130.

A flexible cable 113 may extend from a lower side of the display panel 110 toward a space between the display panel 110 and the horizontal portion 143H of the side frame 140. The flexible cable 113 may extend between the rear surface of the display panel 110 and the material complexed panel 130. For example, the flexible cable 113 may be a COF 113.

A source signal substrate 115 may be electrically connected to the flexible cable 113. The source signal substrate 115 may be fixed to one surface of the flexible cable 113. For example, the source signal substrate 115 may be an S-PCB 115. The source signal substrate 115 may be positioned in the receiving part 137 of the material complexed panel 130.

The flexible cable 113 may be positioned between the protruding pad 138 of the material complexed panel 130 and the display panel 110. The flexible cable 113 may contact the protruding pad 138. Heat generated in the source signal substrate 115 and/or the flexible cable 113 may be dissipated through the protruding pad 138.

A heat dissipation pad 114 may be disposed between the flexible cable 113 in contact with the protruding pad 138 and the rear surface of the display panel 110. The heat dissipation pad 114 may include a core 114a and a conductive film 114b. The core 114a of the heat dissipation pad 114 may be formed of an elastic material, and the conductive film 114b may cover the core 114a of the heat dissipation pad 114. Accordingly, the flexible cable 113 may remain in contact with the protruding pad 138.

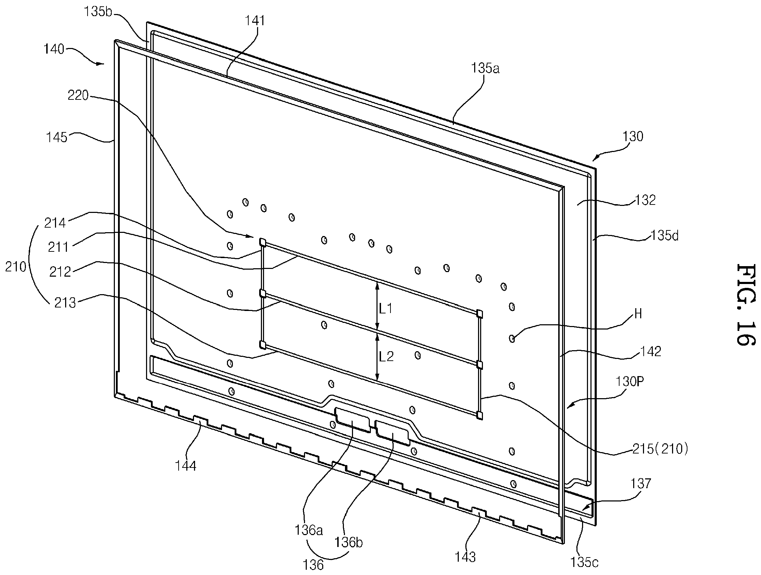

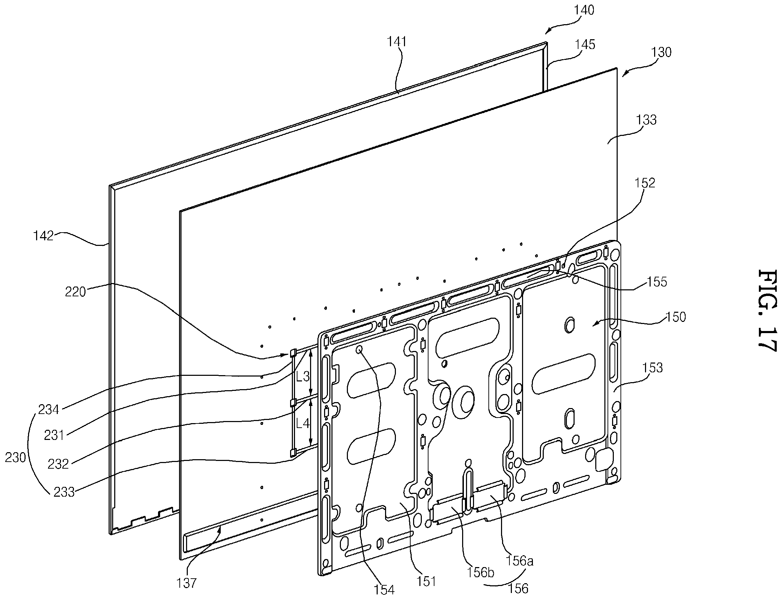

Referring to FIGS. 16 and 17, an inner frame (210, 230) may be formed on the front surface and/or the rear surface of the material complexed panel 130. The inner frame (210, 230) may be referred to as a pressed frame (210, 230) or a rigid line (210, 230). The inner frame (210, 230) is formed in such a manner that the front skin 132 and/or the rear skin 133 of the material complexed panel 130 is recessed and the core 131 (see FIG. 2) is pressed.

The inner frame (210, 230) may include a front inner line 210, a rear inner line 230, and a node hole 220. The front inner line 210 may be formed in such a manner that the front skin 132 of the material complexed panel 130 is recessed. The rear inner line 230 may be formed in such a manner that the rear skin 133 of the material complexed panel 130 is recessed.

The front inner line 210 may include a first front horizontal line 211, a second front horizontal line 212, a third front horizontal line 213, a first front vertical line 214, and a second front vertical line 215. The first front horizontal line 211 may define an upper side of the front inner line 210. The third front horizontal line 213 may define a lower side of the front inner line 210. The second front horizontal line 212 may be positioned between the first front horizontal line 211 and the third front horizontal line 213. The first front vertical line 214 may connect one end of the first front horizontal line 211, one end of the second horizontal line 212, and one end of the third front horizontal line 213. The second front vertical line 215 may connect the other end of the first front horizontal line 211, the other end of the second front horizontal line 212, and the other end of the third front horizontal line 213. For example, a first distance L1 between the first front horizontal line 211 and the second front horizontal line 212 may be less than a second distance L2 between the second front horizontal line 212 and the third front horizontal line 213.

The node hole 220 may be formed at a point where the front horizontal line 211, 212, 213 and the front vertical line 214, 215 meet. The node hole 220 may be formed through the front skin 132, the core 131, and the rear skin 133 of the material complexed panel 130.

The rear inner line 230 may include a first rear horizontal line 231, a second rear horizontal line 232, a third rear horizontal line 233, a first rear vertical line 234, and a second rear vertical line 235 (not shown). The first rear horizontal line 231 may define an upper side of the rear inner line 230. The third rear horizontal line 233 may define a lower side of the rear inner line 230. The second rear horizontal line 232 may be positioned between the first rear horizontal line 231 and the third rear horizontal line 233. The first rear vertical line 234 may connect one end of the first rear horizontal line 231, one end of the second rear horizontal line 232, and one end of the third rear horizontal line 233. The second rear vertical line 235 (not shown) may connect the other end of the first rear horizontal line 231, the other end of the second rear horizontal line 232, and the other end of the third rear horizontal line 233. For example, a third distance L3 between the first rear horizontal line 231 and the second rear horizontal line 232 may be less than a fourth distance L4 between the second rear horizontal line 232 and the third rear horizontal line 233.

The node hole 220 may be formed at a point where the rear horizontal line 231, 232, 233 and the rear vertical line 234, 235 meet. The node hole 220 may be formed through the front skin 132, the core 131, and the rear skin 133 of the material complexed panel 130.

A length of the rear inner line 230 may be less than a length of the PCB plate 150. A width of the rear inner line 230 may be less than a width of the PCB plate 150. The PCB plate 150 may cover the rear inner line 230.

Accordingly, it is possible to increase bending rigidity and/or torsional rigidity of the material complexed panel 130.

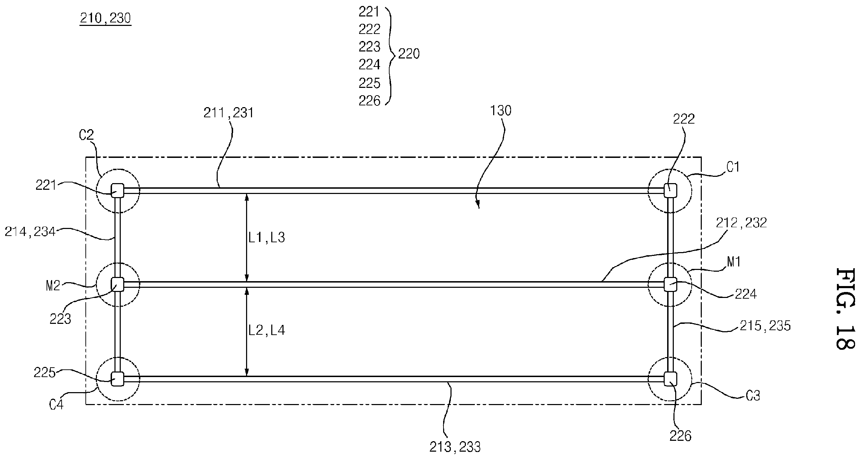

Referring to FIG. 18, a plurality of node holes 220 may be provided. The plurality of node holes 220 may include a first node hole 221, a second node hole 222, a third node hole 223, a fourth node hole 224, a fifth node hole 225, and a sixth node hole 226.

The first node hole 221 may be positioned at a corner C2 formed by the first horizontal line 211, 231 and the first vertical line 214, 234. The first node hole 221 may be formed through the material complexed panel 130 at the conner C2 between the first horizontal line 211, 231 and the first vertical line 214, 234.

The second node hole 222 may be positioned at a conner C1 formed by the first horizontal line 211, 231 and the second vertical line 212, 232. The second node hole 222 may be formed through the material complexed panel 130 at the corner C1 between the first horizontal line 211, 231 and the second vertical line 212, 232.

The third node hole 223 may be positioned at a node M2 formed by the second horizontal line 212, 232 and the first vertical line 214, 234. The third node hole 223 may be formed through the material complexed panel 130 at the node M2 between the second horizontal line 212, 232 and the first vertical line 214, 234.

The fourth node hole 224 may be positioned at a node M1 formed by the second horizontal line 212, 232 and the second vertical line 212, 232. The fourth node hole 224 may be formed through the material complexed panel 130 at the node M1 between the second horizontal line 212, 232 and the second vertical line 212, 232.

The fifth node hole 225 may be positioned at a corner C4 formed by the third horizontal line 213, 233 and the first vertical line 214, 234. The fifth node hole 225 may be formed through the material complexed panel 130 at the corner C4 between the third horizontal line 213, 233 and the first vertical line 214, 234.

The sixth node hole 226 may be positioned at a corner C3 formed by the third horizontal line 213, 233 and the second vertical line 212, 232. The sixth node hole 226 may be formed through the material complexed panel 130 at the corner C3 between the third horizontal line 213, 233 and the second vertical line 212, 232.

Accordingly, it is possible to not only increase bending rigidity and/or torsional rigidity of the material complexed panel 130 but also to improve flatness of the display panel 110 coupled to the material complexed panel 130.

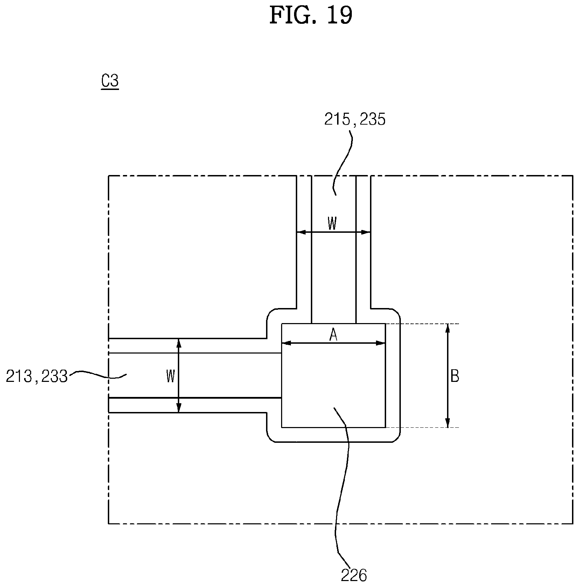

Referring to FIG. 19, the size of the sixth node hole 226 may be greater than the width of the third horizontal line 213, 233 and/or the second vertical line 215, 235. For example, when the sixth node hole 226 is formed in a square shape, a width A, B of the sixth node hole 226 may be greater than a width W of the third horizontal line 213, 233 and/or the second vertical line 215, 235. As another example, when the sixth node hole 226 is formed in a circular shape, a diameter of the sixth node hole 226 may be greater than the width of the third horizontal line 213, 233 and/or the second vertical line 215, 235. The description of the sixth node hole 226 is equally applicable to the first node hole 221, the second node hole 222, and/or the fifth node hole 225.

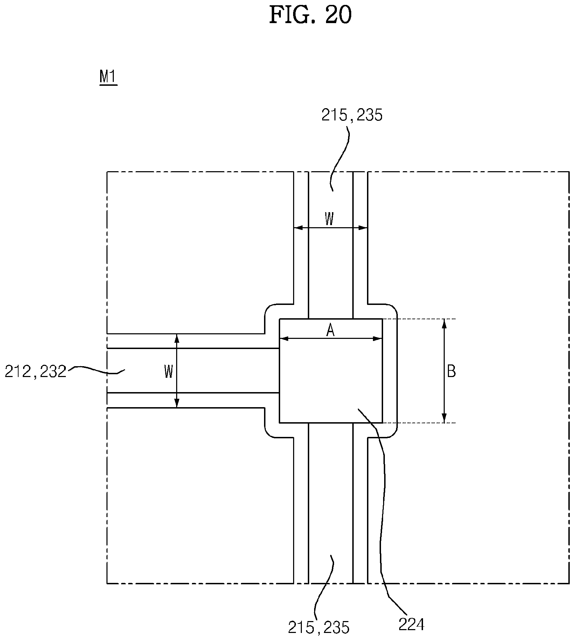

Referring to FIG. 20, the size of the fourth node hole 224 may be greater than the width of the second horizontal line 212, 232 and/or the second vertical line 215, 235. For example, when the fourth node hole 224 is formed in a square shape, a width A, B of the fourth node hole 224 may be greater than a width W of the second horizontal line 212, 232 and/or the second vertical line 215, 235. As another example, when the fourth node hole 224 is formed in a circular shape, a diameter of the fourth node hole 224 may be greater than the width of the second horizontal line 212, 232 and/or the second vertical line 215, 235. The description of the fourth node hole 224 is equally appliable to the third node hole 223.

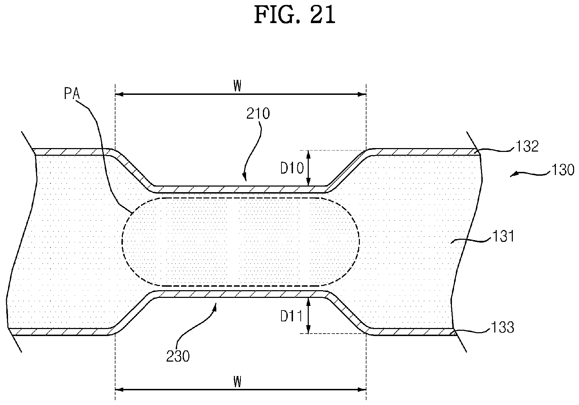

Referring to FIG. 21, as the core 131 is pressed and the front skin 132 is recessed, the front inner line 210 may be formed on the material complexed panel 130. As the core 131 is pressed and the rear skin 133 is recessed, the rear inner line 230 may be formed on the material complexed panel 130.

The front inner line 210 and the rear inner line 230 may be symmetric with respect to the core 131. For example, a width W of the front inner line 210 may be substantially equal to a width W of the rear inner line 230. As another example, a depth D10 of the front inner line 210 may be substantially equal to a depth D11 of the rear inner line 230.

A pressed area PA caused by the core 131 being pressed may be formed between the front inner line 210 and the rear inner line 230. The density of the core 131 in the pressed area PA may be greater than the density of the core 131 in a non-pressed area.

Accordingly, it is possible to increase bending rigidity and/or torsional rigidity of the material complexed panel 130.

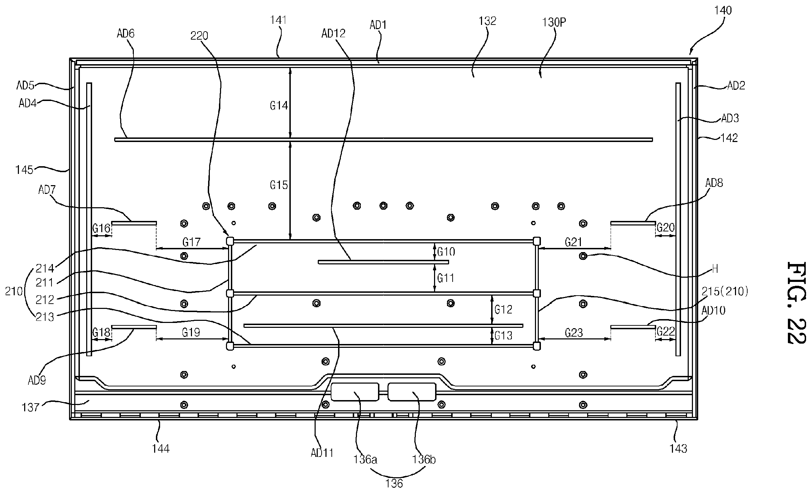

Referring to FIG. 22, an adhesive member AD may be disposed on the flat plate part 130P of the material complexed panel 130. The adhesive member AD may be attached to the front skin 132 of the material complexed panel 130. The adhesive member AD may be provided in plurality.

A first adhesive member AD1 may be fixed to the first part 141 of the side frame 140. The first adhesive member AD1 may be elongated along a longitudinal direction of the first part 141 of the side frame 140. A second adhesive member AD2 may be elongated along a longitudinal direction of the second part 142 of the side frame 140, and may be fixed to the second part 142. A third adhesive member AD3 may be elongated along the second part 142 of the side frame 140, may be parallel to the second part 142, and may be fixed to the flat plate part 130P while being spaced apart from the first adhesive member AD1.

A fifth adhesive member AD5 may be elongated along a longitudinal direction of the fifth part 145 of the side frame 140, and may be fixed to the fifth part 145. A fourth adhesive member AD4 may be elongated along the fifth part 145 of the side frame 140, may be parallel to the fifth part 145, and may be fixed to the flat plate part 130P while being spaced apart from the fifth adhesive member AD5.

A sixth adhesive member AD6 may be elongated along the longitudinal direction of the first part 141 of the side frame 140, and may be fixed to the flat plate part 130P while being spaced apart from the first adhesive member AD1. A fourteenth distance G14 from the first part 141 of the side frame 140 to the sixth adhesive member AD6 may be less than a fifteenth distance G15 from the sixth adhesive member AD6 to the first front horizontal inner line 211.

A seventh adhesive member AD7 may extend along a longitudinal direction of the sixth adhesive member AD6, and may be fixed to the flat plate part 130P between the first front vertical line 214 and the fourth adhesive member AD4. The seventh adhesive member AD7 may be positioned between the sixth adhesive member AD6 and a ninth adhesive member AD9. A sixteenth distance G16 from the fourth adhesive member AD4 to one end of the seventh adhesive member AD7 may be less than a seventeenth distance G17 from the first front vertical line 214 to the other end of the seventh adhesive member AD7.

The ninth adhesive member AD9 may extend along the longitudinal direction of the sixth adhesive member AD6, and may be fixed to the flat plate part 130P between the first front vertical line 214 and the fourth adhesive member AD4. The ninth adhesive member AD9 may be positioned between the seventh adhesive member AD7 and the receiving part 137. An eighteenth distance G18 from the fourth adhesive member AD4 to one end of the ninth adhesive member AD9 may be less than a nineteenth distance G19 from the first front vertical line 214 to the other end of the ninth adhesive member AD9.

An eighth adhesive member AD8 may extend along the longitudinal direction of the sixth adhesive member AD6, and may be fixed to the flat plate part 130P between the second front vertical line 215 and the third adhesive member AD3. The eighth adhesive member AD8 may be positioned between the sixth adhesive member AD6 and the receiving part 137. A twentieth distance G20 from the third adhesive member AD3 to one end of the eighth adhesive member AD8 may be less than a twenty-first distance G21 from the second front vertical line 215 to the other end of the eighth adhesive member AD8.

A tenth adhesive member AD10 may extend along the longitudinal direction of the sixth adhesive member AD6, and may be fixed to the flat plate part 130P between the second front vertical line 215 and the third adhesive member AD3. The tenth adhesive member AD10 may be positioned between the eighth adhesive member AD8 and the receiving part 137. A twenty-second distance G22 from the third adhesive member AD3 to one end of the tenth adhesive member AD10 may be less than a twenty-third distance G23 from the second front vertical line 215 to the other end of the tenth adhesive member AD10.

An eleventh adhesive member AD11 may be elongated along a longitudinal direction of the second front horizontal line 212, and may be fixed to the flat plate part 130P between the second front horizontal line 212 and the third front horizontal line 213. A twelfth adhesive member AD12 may be elongated along the longitudinal direction of the second front horizontal line 212, and may be fixed to the flat plate part 130P between the first front horizontal line 211 and the second front horizontal line 212. A length of the twelfth adhesive member AD12 may be less than a length of the eleventh adhesive member AD11.

A tenth distance G10 between the first front horizontal line 211 and the twelfth adhesive member AD12 may be less than an eleventh distance G11 between the twelfth adhesive member AD12 and the second front horizontal line 212. For example, the tenth distance G10 may be 40 mm or more. For example, a distance between one end of the twelfth adhesive member AD12 and the first vertical front line 214 may be 20 mm or more. As another example, a distance between the other end of the twelfth adhesive member AD12 and the second vertical front line 215 may be 20 mm or more.

A twelfth distance G12 between the second front horizontal line 212 and the eleventh adhesive member AD11 may be greater than a thirteenth distance G13 between the eleventh adhesive member AD11 and the third front horizontal line 213. For example, the thirteenth distance G13 may be 40 mm or more.

The display panel 110 may be coupled or fixed to the material complexed panel 130 by the adhesive member AD. Accordingly, the display panel 110 may be fixed to the material complexed panel 130 in a flat manner.

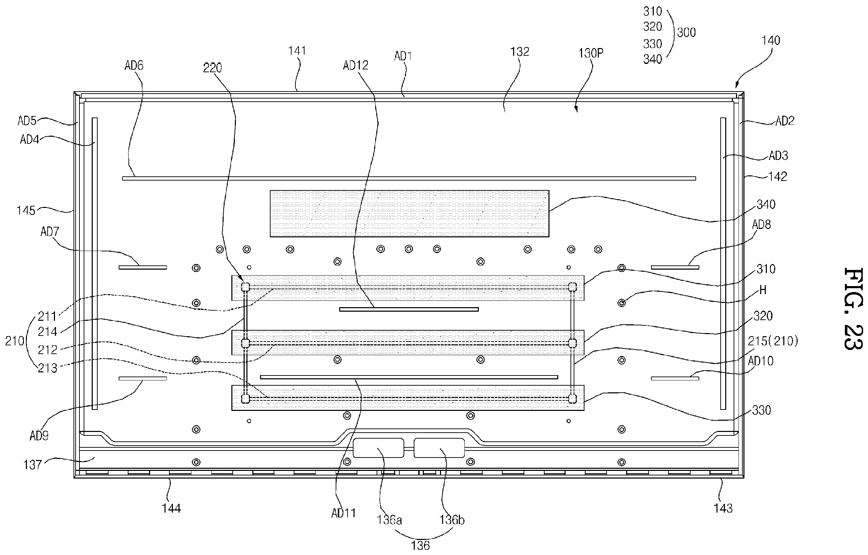

Referring to FIG. 23, a heat dissipation sheet 300 is disposed on the front skin 132 of the material complexed panel 130. The heat dissipation sheet 300 may be attached to the flat plate part 130P of the material complexed panel 130. The heat dissipation sheet 300 may cover the front inner line 211, 212, 213 of the inner frame 210 and/or the node hole 220. For example, the heat dissipation sheet 300 may be an aluminum sheet. The heat dissipation sheet 300 may be attached to the flat plate part 130P of the material complexed panel 130. The heat dissipation sheet 300 may be referred to as a front heat dissipation sheet 300.

A first heat dissipation sheet 310 may be elongated along the first front horizontal line 211, and may be attached to the flat plate part 130P while covering the first front horizontal line 211 and/or the node hole 220. A second heat dissipation sheet 320 may be elongated along the second front horizontal line 212, and may be attached to the flat plate part 130P while covering the second front horizontal line 212 and/or the node hole 220. A third heat dissipation sheet 330 may be elongated along the third front horizontal line 213, and may be attached to the flat plate part 130P while covering the third front horizontal line 213 and/or the node hole 220.

A fourth heat dissipation sheet 340 may be disposed between the first front horizontal line 211 and the sixth adhesive member AD6. The fourth heat dissipation sheet 340 may be elongated along the first front horizontal line 211, and may be attached to the flat plate part 130P. For example, a length of the fourth heat dissipation sheet 340 may be less than a length of the first heat dissipation sheet 310. A width of the fourth heat dissipation sheet 340 may be greater than a width of the first heat dissipation sheet 310.

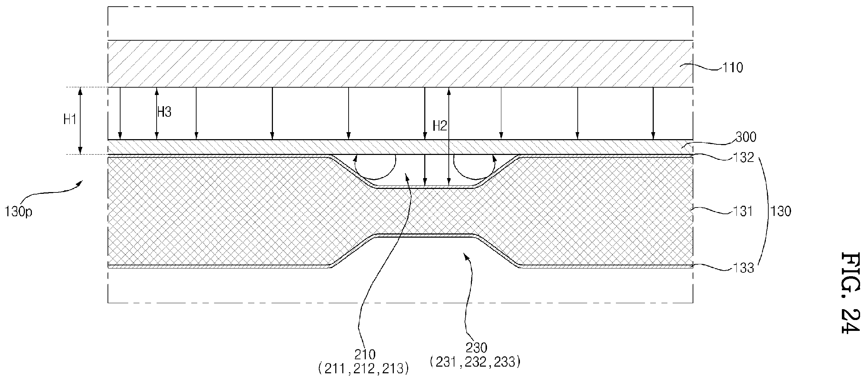

Referring to FIG. 24, the heat dissipation sheet 300 may be positioned between the display panel 110 and the material complexed panel 130. The heat dissipation sheet 300 may be in contact with the flat plate part 130P of the material complexed panel 130. The heat dissipation sheet 300 may cover the front inner line 211, 212, 213 of the inner frame 210. The display panel 110 may be spaced apart from the heat dissipation sheet 300. A distance (or a gap) H1 between the display panel 110 and the material complexed panel 130 may correspond to the thickness of the adhesive member AD (see FIG. 22). For example, the thickness of the adhesive member AD may be the gap between the material complexed panel 130 and the display panel 110.

Referring also to FIG. 23, as the fourth heat dissipation sheet 340 is positioned between the front skin 132 of the flat plate part 130P of the material complexed panel 130 and the display panel 110, a distance H3 between the display panel 110 and the heat dissipation sheet 300 may be less than the distance H1 between the display panel 110 and the material complexed panel 130. Accordingly, it is possible to enhance heat conduction and diffusion between the display panel 110 and the material complexed panel 130.

Heat generated from the display panel 110 may be discharged or emitted to the material complexed panel 130. Heat emitted from the display panel 110 may be transferred to the front skin 132 of the material complexed panel 130. As the front skin 132 of the front inner line 211, 212, 213 of the inner frame 210 is recessed, heat emitted from the display panel 110 may not be spread uniformly.

The core 131 of the material complexed panel 130 may block heat generated in the display panel 110 from passing through. Heat generated in the display panel 110 should be evenly spread across the front of the material complexed panel 130, and heat concentration may degrade the performance of the display panel 110. Heat generated in the display panel 110 may be concentrated by the front inner line 211, 212, 213 of the inner frame 210. A distance H2 between the display panel 110 and the front skin 132 of the front inner line 211, 212, 213 may be greater than the distance H1 between the display panel 110 and the front skin 132 of the material complexed panel 130. This may cause heat generated in the display panel 110 to be concentrated.

Heat generated from the display panel 110 may be emitted to the heat dissipation sheet 300. The heat dissipation sheet 300 may conduct and diffuse heat generated from the display panel 110. The heat dissipation sheet 300 may transfer heat generated from the display panel 110 to the front skin 132 of the material complexed panel 130, thereby improving the heat diffusion effect.

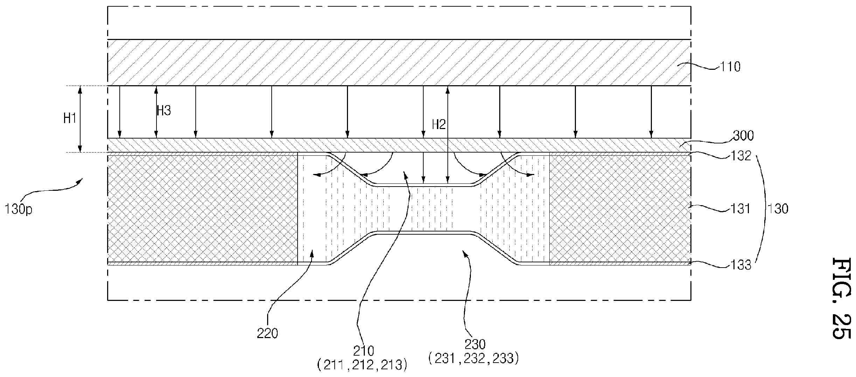

Referring to FIG. 25, the heat dissipation sheet 300 may be positioned between the display panel 110 and the material complexed panel 130. The heat dissipation sheet 300 may be in contact with the flat plate part 130P of the material complexed panel 130. The heat dissipation sheet 300 may cover the front inner line 211, 212, 213 of the inner frame 210 and the node hole 220. The display panel 110 may be spaced apart from the heat dissipation sheet 300. A distance (or a gap) H1 between the display panel 110 and the material complexed panel 130 may correspond to the thickness of the adhesive member AD (see FIG. 22). For example, the thickness of the adhesive member AD may be the gap between the material complexed panel 130 and the display panel 110.

Referring also to FIG. 23, as the first heat dissipation sheet 310, the second heat dissipation sheet 320, and/or the third heat dissipation sheet 330 are positioned between the front skin 132 of the flat plate part 130P of the material complexed panel 130 and the display panel 110, a distance H3 between the display panel 110 and the heat dissipation sheet 300 may be less than the distance H1 between the display panel 110 and the material complexed panel 130. Accordingly, it is possible to enhance heat conduction and diffusion between the display panel 110 and the material complexed panel 130.

Heat generated from the display panel 110 may be discharged or emitted to the material complexed panel 130. Heat emitted from the display panel 110 may be transferred to the front skin 132 of the material complexed panel 130. As the front skin 132 of the front inner line 211, 212, 213 of the inner frame 210 is recessed, and the node hole 220 is formed through the front skin 132, the rear skin 133, and the core 131, heat emitted from the display panel 110 may not be spread uniformly.

Heat generated in the display panel 110 should be evenly spread across the front of the material complexed panel 130, and heat concentration or heat inflow may degrade the performance of the display panel 110. Heat generated in the display panel 110 may be concentrated by the front inner line 211, 212, 213 of the inner frame 210. Heat may be introduced into the display panel 110 through the node hole 220. A distance H2 between the display panel 110 and the front skin 132 of the front inner line 211, 212, 213 may be greater than the distance H1 between the display panel 110 and the front skin 132 of the material complexed panel 130. This may cause heat generated in the display panel 110 to be concentrated.

Heat generated from the display panel 110 may be emitted to the heat dissipation sheet 300. The heat dissipation sheet 300 may conduct and diffuse heat generated from the display panel 110. The heat dissipation sheet 300 may transfer heat generated from the display panel 110 to the front skin 132 of the material complexed panel 130, thereby improving the heat diffusion effect.

Heat introduced from the rear of the material complexed panel 130 through the node hole 220 may be conducted and diffused via the heat dissipation sheet 300. The heat dissipation sheet 300 may block heat introduced through the node hole 220 from being directly transferred to the display panel 110.

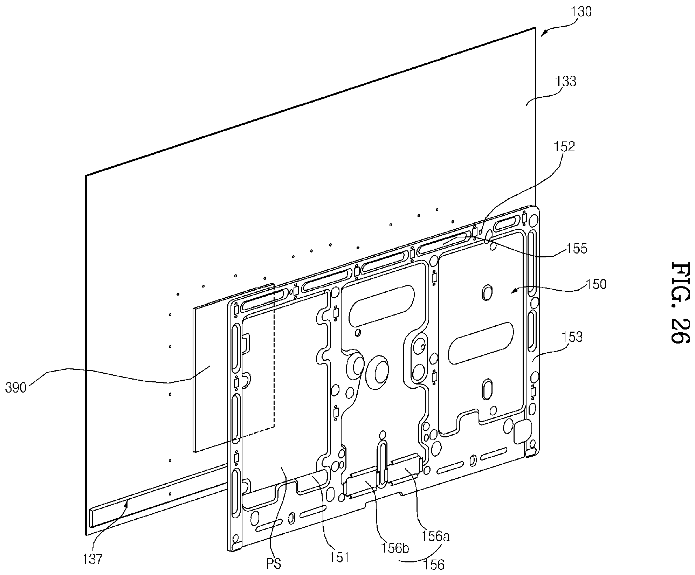

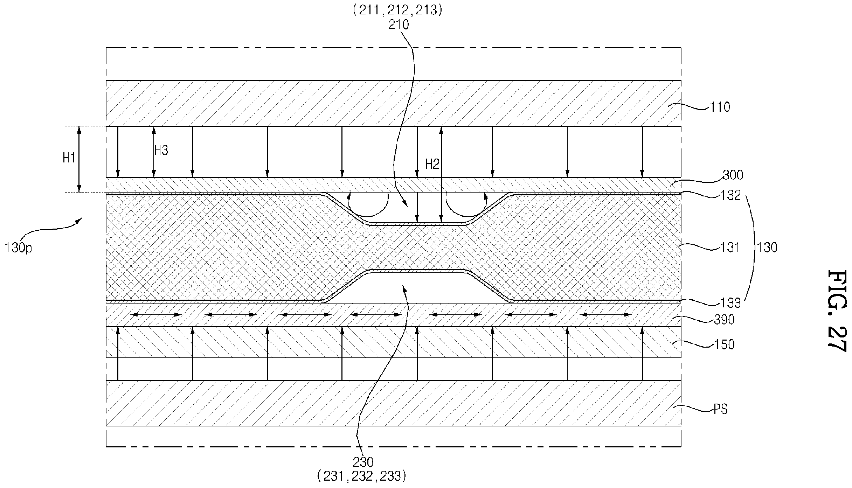

Referring to FIGS. 26 and 27, a heat dissipation sheet 390 is disposed on a rear surface of the material complexed panel 130 between the material complexed panel 130 and the PCB plate 150. The heat dissipation sheet 390 may be referred to as a rear heat dissipation sheet 390. For example, the rear heat dissipation sheet 390 may be a graphite sheet. A power supply unit PS may be disposed at the rear of the PCB plate 150, and may be mounted on the PCB plate 150. The rear heat dissipation sheet 390 may be aligned at the position of the power supply unit PS. For example, the area of the rear heat dissipation sheet 390 may correspond to the area of the power supply unit PS.

The front heat dissipation sheet 300 is positioned between the display panel 110 and the material complexed panel 130. The front heat dissipation sheet 300 may be in contact with the flat plate part 130P of the material complexed panel 130. The front heat dissipation sheet 300 may cover the front inner line 211, 212, 213 of the inner frame 210. The display panel 110 may be spaced apart from the front heat dissipation sheet 300. A distance (or a gap) H1 between the display panel 110 and the material complexed panel 130 may correspond to the thickness of the adhesive member AD (see FIG. 22).

Heat generated from the display panel 110 may be discharged or emitted to the material complexed panel 130. Heat emitted from the display panel 110 may be transferred to the front skin 132 of the material complexed panel 130. As the front skin 132 of the front inner line 211, 212, 213 of the inner frame 210 is recessed, heat emitted from the display panel 110 may not be spread uniformly.

The core 131 of the material complexed panel 130 may block heat generated in the display panel 110 from passing through. Heat generated in the display panel 110 should be evenly spread across the front of the material complexed panel 130, and heat concentration may degrade the performance of the display panel 110. Heat generated in the display panel 110 may be concentrated by the front inner line 211, 212, 213 of the inner frame 210. A distance H2 between the display panel 110 and the front skin 132 of the front inner line 211, 212, 213 may be greater than the distance H1 between the display panel 110 and the front skin 132 of the material complexed panel 130. This may cause heat generated in the display panel 110 to be concentrated.

Heat generated from the display panel 110 may be emitted to the front heat dissipation sheet 300. The front heat dissipation sheet 300 may conduct and diffuse heat generated from the display panel 110. The front heat dissipation sheet 300 may transfer heat generated from the display panel 110 to the front skin 132 of the material complexed panel 130, thereby improving the heat diffusion effect.

The rear heat dissipation sheet 390 may be in contact with the rear skin 133 of the material complexed panel 130 and the PCB plate 150. According to the claimed subject-matter, the rear heat dissipation sheet 390 is attached to the rear skin 133 of the material complexed panel 130, and may form an air gap with the PCB plate 150. Heat generated from the power supply unit PS may be high-temperature heat. Heat generated from the power supply unit PS may be directed to the rear skin 133 of the material complexed panel 130 through the PCB plate 150. The rear heat dissipation sheet 390 may diffuse heat transferred through the PCB plate 150. The rear heat dissipation sheet 390 may minimize the transfer of heat to the rear skin 133 of the material complexed panel 130, and may diffuse heat throughout the rear heat dissipation sheet 390. The core 131 of the material complexed panel 130 may block heat transferred to the rear skin 133 via the rear heat dissipation sheet 390. Accordingly, it is possible to achieve effective heat dissipation and insulation of the display panel 110.

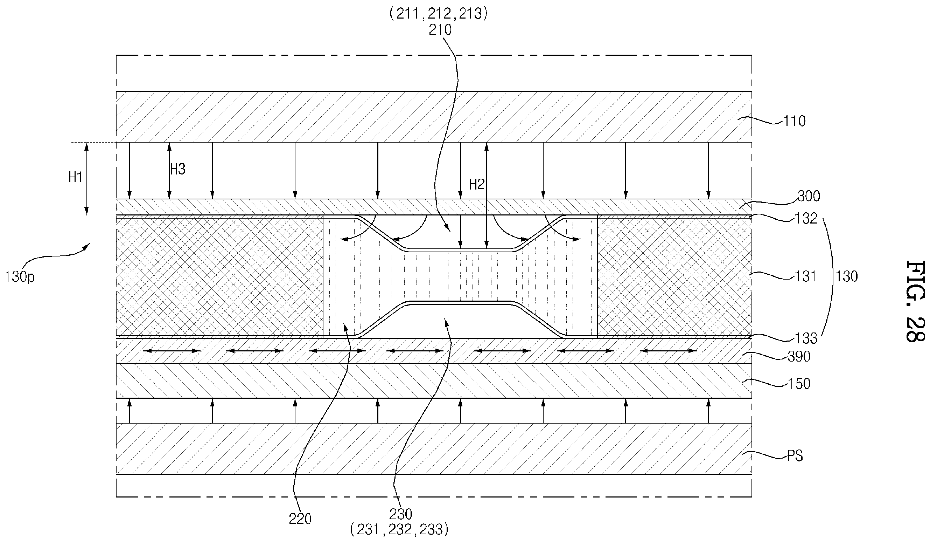

Referring to FIG. 28, the front heat dissipation sheet 300 is positioned between the display panel 110 and the material complexed panel 130. The front heat dissipation sheet 300 may be in contact with the flat plate part 130P of the material complexed panel 130. The front heat dissipation sheet 300 may cover the front inner line 211, 212, 213 of the inner frame 210 and the node hole 220. The display panel 110 may be spaced apart from the front heat dissipation sheet 300. A distance (or a gap) H1 between the display panel 110 and the material complexed panel 130 may correspond to the thickness of the adhesive member AD (see FIG. 22). For example, the thickness of the adhesive member AD may be the gap between the material complexed panel 130 and the display panel 110.

Referring also to FIG. 23, as the first front heat dissipation sheet 310, the second front heat dissipation sheet 320, and/or the third front heat dissipation sheet 330 are positioned between the front skin 132 of the flat plate part 130P of the material complexed panel 130 and the display panel 110, a distance H3 between the display panel 110 and the front heat dissipation sheet 300 may be less than the distance H1 between the display panel 110 and the material complexed panel 130. Accordingly, it is possible to enhance heat conduction and diffusion between the display panel 110 and the material complexed panel 130.

Heat generated from the display panel 110 may be discharged or emitted to the material complexed panel 130. Heat emitted from the display panel 110 may be transferred to the front skin 132 of the material complexed panel 130. As the front skin 132 of the front inner line 211, 212, 213 of the inner frame 210 is recessed, and the node hole 220 is formed through the front skin 132, the rear skin 133, and the core 131, heat emitted from the display panel 110 may not be spread uniformly.

Heat generated in the display panel 110 should be evenly spread across the front of the material complexed panel 130, and heat concentration or heat inflow may degrade the performance of the display panel 110. Heat generated in the display panel 110 may be concentrated by the front inner line 211, 212, 213 of the inner frame 210. Heat may be introduced into the display panel 110 through the node hole 220. A distance H2 between the display panel 110 and the front skin 132 of the front inner line 211, 212, 213 may be greater than the distance H1 between the display panel 110 and the front skin 132 of the material complexed panel 130. This may cause heat generated in the display panel 110 to be concentrated.

Heat generated from the display panel 110 may be emitted to the front heat dissipation sheet 300. The front heat dissipation sheet 300 may conduct and diffuse heat generated from the display panel 110. The front heat dissipation sheet 300 may transfer heat generated from the display panel 110 to the front skin 132 of the material complexed panel 130, thereby improving the heat diffusion effect.

The rear heat dissipation sheet 390 may be in contact with the rear skin 133 of the material complexed panel 130 and the PCB plate 150. According to the claimed subject-matter, the rear heat dissipation sheet 390 is may attached to the rear skin 133 of the material complexed panel 130, and may form an air gap with the PCB plate 150. Heat generated from the power supply unit PS may be high-temperature heat. Heat generated from the power supply unit PS may be directed to the rear skin 133 of the material complexed panel 130 through the PCB plate 150. The rear heat dissipation sheet 390 may diffuse heat transferred through the PCB plate 150. The rear heat dissipation sheet 390 may minimize or block the transfer of heat to the rear skin 133 of the material complexed panel 130, and may diffuse heat throughout the rear heat dissipation sheet 390.

Heat introduced from the rear of the material complexed panel 130 through the node hole 220 may be conducted and diffused via the rear heat dissipation sheet 390. The front heat dissipation sheet 300 and/or the rear heat dissipation sheet 390 may block heat introduced through the node hole 220 from being directly transferred to the display panel 110.

Accordingly, it is possible to achieve effective heat dissipation and insulation of the display panel 110.

Referring to FIGS. 1 to 28, a display device includes: a display panel 110; a material complexed plate 130 disposed at a rear of the display panel 110; and a side frame 140 disposed between the display panel 110 and the material complexed plate 130, fixed to the material complexed plate 130, and to which the display panel 110 is coupled. The material complexed plate 130 may include: a front skin 132 forming a front surface; a rear skin 133 forming a rear surface and facing the front skin 132; a core 131 disposed between the front skin 132 and the rear skin 133 and including fibers; and an inner frame (210, 230) formed by the front skin 132 or the rear skin 133 being recessed. The material complexed plate 130 further includes a first heat dissipation sheet 300 that is disposed between the display panel 110 and the front skin 132, is adjacent to or overlaps the inner frame (210, 230), and is attached to the front skin 132.

The material complexed plate 130 may further include an adhesive member AD fixed to the front skin 132 of the material complexed plate 130 and coupled with a rear surface of the display panel 110. A thickness of the first heat dissipation sheet 300 may be less than a thickness of the adhesive member AD.

The inner frame (210, 230) may include: a front inner line 210 formed by the front skin 132 being recessed; and a rear inner line 230 formed by the rear skin 133 being recessed. The first heat dissipation sheet 300 may be attached to the front skin 132 while covering the front inner line 210.

The front inner line 210 may include: a front horizontal line 211, 212, 213 elongated in one direction; and a front vertical line 214, 215 elongated in a direction intersecting the one direction. The material complexed plate 130 may further include a node hole 220 formed through the front skin 132 and the rear skin 133 at a point where the front horizontal line 211, 212, 213 and the front vertical line 214, 215 intersect. The first heat dissipation sheet 300 may cover the front horizontal line 211, 212, 213 and the node hole 220.

The first heat dissipation sheet 300 may cover at least a portion of the front vertical line 214, 215.

The material complexed plate 130 further includes a second heat dissipation sheet 390 disposed opposite the first heat dissipation sheet 300 with respect to the core 131 of the material complexed plate 130 and attached to the rear skin 133.

The display device may further include: a PCB plate 150 disposed at a rear of the material complexed plate 130 and fixed to the rear skin 133 while covering the second heat dissipation sheet 390; and a power supply unit PS disposed at a rear of the PCB plate 150 and coupled to the PCB plate 150. A position of the second heat dissipation sheet 390 may correspond to a position of the power supply unit PS.

The front inner line 210 may include: a front horizontal line 211, 212, 213 formed in an elongated manner; and a front vertical line 214, 215 intersecting the front horizontal line 211, 212, 213. The rear inner line 230 may include: a rear horizontal line 231, 232, 233 disposed opposite the front horizontal line 211, 212, 213 with respect to the core 131; and a rear vertical line 234, 235 disposed opposite the front vertical line 214, 215 with respect to the core 131 and intersecting the rear horizontal line 231, 232, 233.

A density of the core 131 between the front horizontal line 211, 212, 213 and the rear horizontal line 231, 232, 233 or between the front vertical line 214, 215 and the rear vertical line 234, 235 may be greater than a density of the core 131 between the front skin 132 and the rear skin 133.

The node hole 220 may have a square shape, and a length of one side (A, B) of the node hole 220 may be greater than a width W of the front horizontal line 211, 212, 213 or the front vertical line 214, 215.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

## Claims

1. A display device comprising:
a display panel (110);
a material complexed plate (130) disposed at a rear of the display panel (110); and
a side frame (140) disposed between the display panel (110) and the material complexed plate (130), fixed to the material complexed plate (130), and to which the display panel (110) is coupled,
wherein the material complexed plate (130) comprises:
a front skin (132) forming a front surface;
a rear skin (133) forming a rear surface and facing the front skin (132);
a core (131) disposed between the front skin (132) and the rear skin (133), the core (131) including fibers; and
an inner frame (210, 230) formed by the front skin (132) or the rear skin (133) being recessed, and
wherein the material complexed plate (130) further comprises a first heat dissipation sheet (300) that is disposed between the display panel (110) and the front skin (132) and is adjacent to or overlaps the inner frame (210, 230), the first heat dissipation sheet (300) being attached to the front skin (132),
wherein the material complexed plate (130) further comprises a second heat dissipation sheet (390) disposed opposite the first heat dissipation sheet (300) with respect to the core (131) of the material complexed plate (130), the second heat dissipation sheet (390) being attached to the rear skin (133).

2. The display device of claim 1, wherein the material complexed plate (130) further comprises an adhesive member (AD) fixed to the front skin (132) of the material complexed plate (130) and coupled with a rear surface of the display panel (110), and
wherein a thickness of the first heat dissipation sheet (300) is less than a thickness of the adhesive member (AD).

3. The display device of claim 1, wherein the inner frame (210,230) comprises:
a front inner line (210) formed by the front skin (132) being recessed; and
a rear inner line (230) formed by the rear skin (133) being recessed, and
wherein the first heat dissipation sheet (300) is attached to the front skin (132) while covering the front inner line (210).

4. The display device of claim 3, wherein the front inner line (210) comprises:
a front horizontal line (211,212,213) that is elongated in one direction; and
a front vertical line (214,215) that is elongated in a direction intersecting the one direction,
wherein the material complexed plate (130) further comprises a node hole (220) formed through the front skin (132) and the rear skin (133) at a point where the front horizontal line (211,212,213) and the front vertical line (214,215) intersect, and
wherein the first heat dissipation sheet (300) covers the front horizontal line (211,212,213) and the node hole (220).

5. The display device of claim 4, wherein the first heat dissipation sheet (300) covers at least a portion of the front vertical line (214,215).

6. The display device of claim 1, further comprising:
a PCB plate (150) disposed at a rear of the material complexed plate (130) and fixed to the rear skin (133) while covering the second heat dissipation sheet (390); and
a power supply unit (PS) disposed at a rear of the PCB plate (150) and coupled to the PCB plate (150),
wherein a position of the second heat dissipation sheet (390) corresponds to a position of the power supply unit (PS).

7. The display device of claim 3, wherein the front inner line (210) comprises:
a front horizontal line (211,212,213) that is elongated; and
a front vertical line (214,215) that intersects the front horizontal line (211,212,213), and
wherein the rear inner line (230) comprises:
a rear horizontal line (231,232,233) that is opposite the front horizontal line (211,212,213) with respect to the core (131); and
a rear vertical line (234,235) that is opposite the front vertical line (214,215) with respect to the core (131) and intersects the rear horizontal line (231,232,233).

8. The display device of claim 7, wherein a density of the core (131) between the front horizontal line (211,212,213) and the rear horizontal line (231,232,233) or between the front vertical line (214,215) and the rear vertical line (234,235) is greater than a density of the core (131) between the front skin (132) and the rear skin (133).

9. The display device of claim 4, wherein the node hole (220) has a square shape, and a length of one side of the node hole (220) is greater than a width of the front horizontal line (211,212,213) or the front vertical line (214,215).

## Patentansprüche

1. Anzeigevorrichtung, die aufweist:
ein Anzeigefeld (110);
eine Materialverbundplatte (130), die auf der Rückseite des Anzeigefelds (110) angeordnet ist; und
einen Seitenrahmen (140), der zwischen dem Anzeigefeld (110) und der Materialverbundplatte (130) angeordnet ist, an der Materialverbundplatte (130) befestigt ist und mit dem das Anzeigefeld (110) gekoppelt ist,
wobei die Materialverbundplatte (130) aufweist:
eine vordere Haut (132), die eine Vorderseite bildet;
eine hintere Haut (133), die eine Rückseite bildet und der vorderen Haut (132) zugewandt ist;
einen Kern (131), der zwischen der vorderen Haut (132) und der hinteren Haut (133) angeordnet ist, wobei der Kern (131) Fasern enthält; und
einen Innenrahmen (210, 230), der dadurch gebildet wird, dass die vordere Haut (132) oder die hintere Haut (133) ausgespart ist, und
wobei die Materialverbundplatte (130) ferner eine erste Wärmeableitungsfolie (300) aufweist, die zwischen dem Anzeigefeld (110) und der vorderen Haut (132) angeordnet ist und zum Innenrahmen (210, 230) benachbart ist oder diesen überlappt, wobei die erste Wärmeableitungsfolie (300) an der vorderen Haut (132) befestigt ist,
wobei die Materialverbundplatte (130) ferner eine zweite Wärmeableitungsfolie (390) aufweist, die in Bezug auf den Kern (131) der Materialverbundplatte (130) gegenüber der ersten Wärmeableitungsfolie (300) angeordnet ist, wobei die zweite Wärmeableitungsfolie (390) an der hinteren Haut (133) befestigt ist.

2. Anzeigevorrichtung nach Anspruch 1, wobei die Materialverbundplatte (130) ferner ein Klebeelement (AD) aufweist, das an der vorderen Haut (132) der Materialverbundplatte (130) befestigt und mit einer Rückseite des Anzeigefelds (110) gekoppelt ist, und wobei eine Dicke der ersten Wärmeableitungsfolie (300) geringer ist als die Dicke des Klebeelements (AD).

3. Anzeigevorrichtung nach Anspruch 1, wobei der Innenrahmen (210, 230) aufweist:
eine vordere Innenlinie (210), die dadurch gebildet wird, dass die vordere Haut (132) ausgespart ist; und
eine hintere Innenlinie (230), die dadurch gebildet wird, dass die hintere Haut (133) ausgespart ist, und
wobei die erste Wärmeableitungsfolie (300) an der vorderen Haut (132) befestigt ist, während sie die vordere Innenlinie (210) abdeckt.

4. Anzeigevorrichtung nach Anspruch 3, wobei die vordere Innenlinie (210) aufweist:
eine vordere horizontale Linie (211, 212, 213), die sich in einer Richtung erstreckt; und
eine vordere vertikale Linie (214, 215), die sich in einer Richtung erstreckt, die die eine Richtung schneidet,
wobei die Materialverbundplatte (130) ferner ein Knotenloch (220) aufweist, das durch die vordere Haut (132) und die hintere Haut (133) an einer Stelle ausgebildet ist, an der sich die vordere horizontale Linie (211, 212, 213) und die vordere vertikale Linie (214, 215) schneiden, und
wobei die erste Wärmeableitungsfolie (300) die vordere horizontale Linie (211, 212, 213) und das Knotenloch (220) abdeckt.

5. Anzeigevorrichtung nach Anspruch 4, wobei die erste Wärmeableitungsfolie (300) mindestens einen Abschnitt der vorderen vertikalen Linie (214, 215) abdeckt.

6. Anzeigevorrichtung nach Anspruch 1, die ferner aufweist:
eine PCB-Platte (150), die an der Rückseite der Materialverbundplatte (130) angeordnet und an der hinteren Haut (133) befestigt ist, während sie die zweite Wärmeableitungsfolie (390) abdeckt; und
eine Stromversorgungseinheit (PS), die an der Rückseite der PCB-Platte (150) angeordnet und mit der PCB-Platte (150) gekoppelt ist,
wobei eine Position der zweiten Wärmeableitungsfolie (390) einer Position der Stromversorgungseinheit (PS) entspricht.

7. Anzeigevorrichtung nach Anspruch 3, wobei die vordere innere Linie (210) aufweist:
eine vordere horizontale Linie (211, 212, 213), die langgestreckt ist; und
eine vordere vertikale Leitung (214, 215), die die vordere horizontale Leitung (211, 212, 213) schneidet, und
wobei die hintere innere Linie (230) aufweist:
eine hintere horizontale Linie (231, 232, 233), die der vorderen horizontalen Linie (211, 212, 213) in Bezug auf den Kern (131) gegenüberliegt; und
eine hintere vertikale Linie (234, 235), die in Bezug auf den Kern (131) der vorderen vertikalen Linie (214, 215) gegenüberliegt und die hintere horizontale Linie (231, 232, 233) schneidet.

8. Anzeigevorrichtung nach Anspruch 7, wobei eine Dichte des Kerns (131) zwischen der vorderen horizontalen Linie (211, 212, 213) und der hinteren horizontalen Linie (231, 232, 233) oder zwischen der vorderen vertikalen Linie (214, 215) und der hinteren vertikalen Linie (234, 235) größer ist als die Dichte des Kerns (131) zwischen der vorderen Haut (132) und der hinteren Haut (133).

9. Anzeigevorrichtung nach Anspruch 4, wobei das Knotenloch (220) eine quadratische Form aufweist und eine Länge einer Seite des Knotenlochs (220) größer ist als eine Breite der vorderen horizontalen Linie (211, 212, 213) oder der vorderen vertikalen Linie (214, 215).

## Revendications

1. Dispositif d'affichage comprenant :
un panneau d'affichage (110) ;
une plaque en matériau composite (130) disposée à l'arrière du panneau d'affichage (110) ; et
un cadre latéral (140) disposé entre le panneau d'affichage (110) et la plaque en matériau composite (130), fixé à la plaque en matériau composite (130), et auquel le panneau d'affichage (110) est couplé,
dans lequel la plaque en matériau composite (130) comprend :
une peau avant (132) formant une surface avant ;
une peau arrière (133) formant une surface arrière et faisant face à la peau avant (132) ;
un noyau (131) disposé entre la peau avant (132) et la peau arrière (133), le noyau (131) comprenant des fibres ; et
un cadre intérieur (210, 230) formé par un évidement de la peau avant (132) ou de la peau arrière (133), et
dans lequel la plaque en matériau composite (130) comprend en outre une première feuille de dissipation thermique (300) qui est disposée entre le panneau d'affichage (110) et la peau avant (132) et qui est adjacente au cadre intérieur (210, 230) ou le recouvre, la première feuille de dissipation thermique (300) étant fixée à la peau avant (132),
dans lequel la plaque en matériau composite (130) comprend en outre une deuxième feuille de dissipation thermique (390) disposée à l'opposé de la première feuille de dissipation thermique (300) par rapport au noyau (131) de la plaque en matériau composite (130), la deuxième feuille de dissipation thermique (390) étant fixée à la peau arrière (133).

2. Dispositif d'affichage selon la revendication 1, dans lequel la plaque en matériau composite (130) comprend en outre un élément adhésif (AD) fixé à la peau avant (132) de la plaque en matériau composite (130) et couplé à une surface arrière du panneau d'affichage (110), et
dans lequel une épaisseur de la première feuille de dissipation thermique (300) est inférieure à l'épaisseur de l'élément adhésif (AD).

3. Dispositif d'affichage selon la revendication 1, dans lequel le cadre intérieur (210, 230) comprend :
une ligne intérieure avant (210) formée par un évidement de la peau avant (132) ; et
une ligne intérieure arrière (230) formée par un évidement de la peau arrière (133), et
dans lequel la première feuille de dissipation thermique (300) est fixée à la peau avant (132) tout en recouvrant la ligne intérieure avant (210).

4. Dispositif d'affichage selon la revendication 3, dans lequel la ligne intérieure avant (210) comprend :
une ligne horizontale avant (211, 212, 213) qui s'étend dans une direction ; et
une ligne verticale avant (214, 215) qui s'étend dans une direction coupant ladite direction,
dans lequel la plaque en matériau composite (130) comprend en outre un trou nodal (220) formé à travers la peau avant (132) et la peau arrière (133) en un point où la ligne horizontale avant (211, 212, 213) et la ligne verticale avant (214, 215) se croisent, et
dans lequel la première feuille de dissipation thermique (300) recouvre la ligne horizontale avant (211, 212, 213) et le trou nodal (220).

5. Dispositif d'affichage selon la revendication 4, dans lequel la première feuille de dissipation thermique (300) recouvre au moins une partie de la ligne verticale avant (214, 215).

6. Dispositif d'affichage selon la revendication 1, comprenant en outre :
une plaque de circuit imprimé (150) disposée à l'arrière de la plaque en matériau composite (130) et fixée à la peau arrière (133) tout en recouvrant la deuxième feuille de dissipation thermique (390) ; et
une unité d'alimentation (PS) disposée à l'arrière de la plaque de circuit imprimé (150) et couplée à la plaque de circuit imprimé (150),
dans lequel la position de la deuxième feuille de dissipation thermique (390) correspond à la position de l'unité d'alimentation (PS).

7. Dispositif d'affichage selon la revendication 3, dans lequel la ligne intérieure avant (210) comprend :
une ligne horizontale avant (211, 212, 213) qui est allongée ; et
une ligne verticale avant (214, 215) qui coupe la ligne horizontale avant (211, 212, 213), et
dans lequel la ligne intérieure arrière (230) comprend :
une ligne horizontale arrière (231, 232, 233) qui est opposée à la ligne horizontale avant (211, 212, 213) par rapport au noyau (131) ; et
une ligne verticale arrière (234, 235) qui est opposée à la ligne verticale avant (214, 215) par rapport au noyau (131) et qui coupe la ligne horizontale arrière (231, 232, 233).

8. Dispositif d'affichage selon la revendication 7, dans lequel une densité du noyau (131) entre la ligne horizontale avant (211, 212, 213) et la ligne horizontale arrière (231, 232, 233) ou entre la ligne verticale avant (214, 215) et la ligne verticale arrière (234, 235) est supérieure à la densité du noyau (131) entre la peau avant (132) et la peau arrière (133).

9. Dispositif d'affichage selon la revendication 4, dans lequel le trou nodal (220) a une forme carrée, et une longueur d'un côté du trou nodal (220) est supérieure à une largeur de la ligne horizontale avant (211, 212, 213) ou de la ligne verticale avant (214, 215).
